Europäisches Patentamt

European Patent Office

Office européen des brevets

(11) Publication number: **0 052 504**
**B1**

(12) **EUROPEAN PATENT SPECIFICATION**

(45) Date of publication of patent specification: **12.06.85**

(21) Application number: **81305415.2**

(22) Date of filing: **16.11.81**

(51) Int. Cl.⁴: **G 11 C 8/00, H 03 F 1/30,
H 03 K 19/096**

(54) **Semiconductor buffer circuit.**

(30) Priority: **19.11.80 JP 162889/80**

(43) Date of publication of application:
**26.05.82 Bulletin 82/21**

(45) Publication of the grant of the patent:
**12.06.85 Bulletin 85/24**

(84) Designated Contracting States:
**DE FR GB NL**

(56) References cited:
**EP-A-0 032 017
DE-A-2 417 994
DE-B-2 625 007
US-A-3 774 055**

(73) Proprietor: **FUJITSU LIMITED
1015, Kamikodanaka Nakahara-ku
Kawasaki-shi Kanagawa 211 (JP)**

(72) Inventor: **Takemae, Yoshihiro
1-20-5-9-301, Utsukushigaoka
Midori-ku Yokohama-shi Kanagawa 227 (JP)**
Inventor: **Mezawa, Tsutomu
81 Aza Muranishi Oaza Tsuruga Ikkimachi
Aizuwakamatsu-shi Fukushima 965 (JP)**
Inventor: **Enomoto, Seiji
3-16-403, Susukinodanchi
Midori-ku Yokohama-shi Kanagawa 227 (JP)**
Inventor: **Kabashima, Katsuhiko
407-1, Miyauchi Nakahara-ku
Kawasaki-shi Kanagawa 211 (JP)**
Inventor: **Nozaki, Shigeki
473-4-203, Hisasue Takatsu-ku
Kawasaki-shi Kanagawa 213 (JP)**

(74) Representative: **George, Sidney Arthur et al
GILL JENNINGS & EVERY 53-64 Chancery Lane
London WC2A 1HN (GB)**

## Description

This invention relates to a semiconductor buffer circuit which compensates for power supply fluctuations. The circuit may, for example, be used for amplification of a clock signal in a dynamic memory.

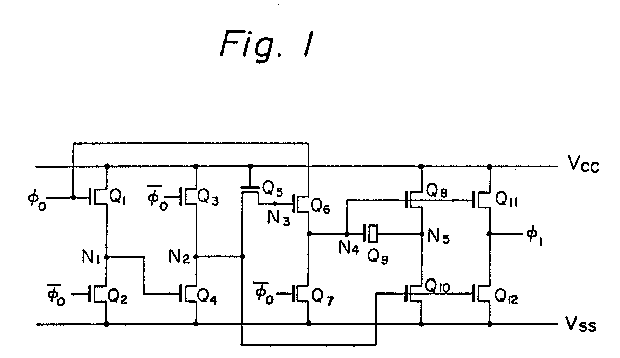

Figs. 1 to 3 of the accompanying drawings illustrate a conventional buffer circuit which amplifies an input clock signal $\phi_0$ ("clock $\phi_0$") with impedance conversion and supplies an output clock signal $\phi_1$ ("clock $\phi_1$"). The circuit comprises MOS transistors Q1 to Q8 and Q10 to Q12, Q9 being an MOS capacitor. The input stage of the buffer circuit is a delay circuit comprising the transistors Q1 to Q4. During a standby period, the delay circuit holds the voltage of a node N2, which connects the source of the transistor Q3 to the drain of the transistor Q4, at a high level by using the input clock $\phi_0$ and an inverted input clock signal $\overline{\phi_0}$ ("clock $\overline{\phi_0}$"). The clock $\phi_0$ is at a high level during an active period and is at a low level during the standby period. The clock $\overline{\phi_0}$, because of the inverted polarity, is at a low level during the active period and is at a high level during the standby period. These clock signals turn off the transistor Q1; turn on transistors Q2 and Q3; hold a node N1 at a low level, which node connects the source of the transistor Q1 to the drain of the transistor Q2 and the gate of the transistor Q4; turn off the transistor Q4; and charge the node N2 to a voltage (Vcc–Vth) via the transistor Q3 during the standby period. Vcc is the voltage at the high potential side of the power supply. It is usually 5 volts which is the standard value, allowing for an error of ±10%. Vth is a threshold voltage of the transistor Q3. The gate of the transistor Q5 is connected to the power supply Vcc. Hence, when the node N2 is charged to the voltage (Vcc–Vth), a node N3 is charged to the same voltage. The node N3 connects the transistor Q5 to the gate of the transistor Q6 to form the gate terminal of the transistor Q6 in a bootstrap circuit comprising the transistors Q5, Q6, Q7, Q8 and Q10. By charging the node N3 to a high level during the standby period, the charged voltage of the node N3 drives an output stage comprising the transistors Q11 and Q12 at a high speed during the next active period. Since the clock $\overline{\phi_0}$ is at a high level during the standby period, the transistor Q7 turns on; a node N4, which interconnects the source of the transistor Q6, the drain of the transistor Q7, the MOS capacitor Q9 and the gate of transistor Q11, turns to a low level; the transistors Q8 and Q11 turn off; and the transistors Q10 and Q12 turn on. The output clock $\phi_1$ is at the low level, which is equal to the low potential side Vss of the power supply (usually ground potential).

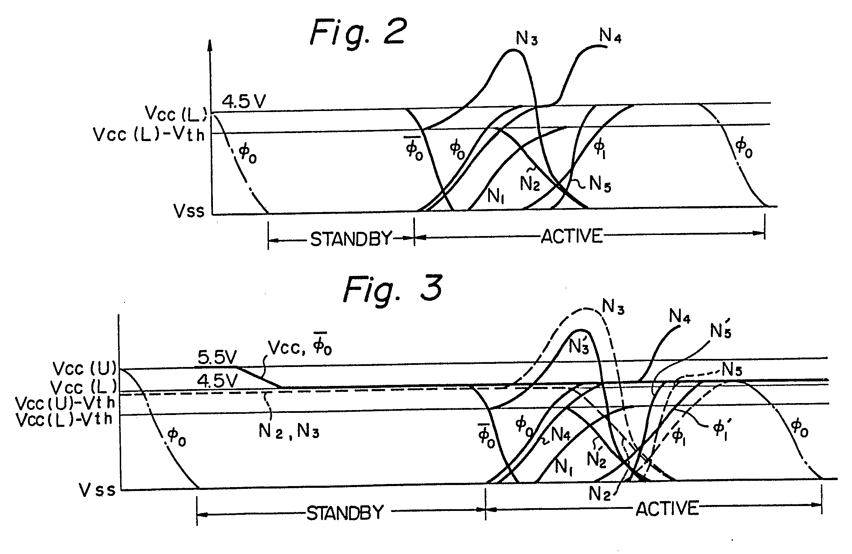

On entering the active period, the input clocks $\phi_0$ and $\overline{\phi_0}$ are inverted. In Fig. 2, waveforms of the operation are shown during the active period, and this example shows the case where Vcc is constant and equal to 4.5 volts. Since, in this example, the voltage of the node N2 is equal to the voltage of the node N3, and the voltage of these nodes is (4.5 volts–Vth), when the clock $\overline{\phi_0}$ is changed from Vcc to Vss and the clock $\phi_0$ is raised from Vss to Vcc, the voltage of the node N3 rises above (Vcc+Vth) and the voltage of the node N4 is charged to the voltage of $\phi_0$, which is equal to Vcc, by the bootstrap effect, which is caused by the effects of the capacitance between the gate and the drain of the transistor Q6 and between the gate and the source of the transistor Q6.

This results in the transistors Q8 and Q11 being turned on. At the same time, since the transistor Q1 turns on, the transistor Q2 turns off; the node N1 is charged up and the transistor Q4 turns on; then the voltage of the node N2 begins the decrease. Accordingly, the electric charge on the node N3 is reduced through the transistor Q5 and the voltage of the nodes N3 and N2 decreases to the voltage Vss. When the voltage of the node N2 falls to a value of (Vss+Vth) the transistors Q10 and Q12 turn off and the voltage of the node N5 rises to Vcc. At this time, since the voltage of the node N4 is rasied above the voltage (Vcc+Vth) through the capacitor Q9, the output clock $\phi_1$ rises to the maximum voltage level Vcc.

The above operation has been described on the assumption that no fluctuation in the power supply level occurs. However, as shown in Fig. 3, if a variation in the power supply voltage does occur during the standby period, the output clock $\phi_1$ is delayed, and this delay poses a problem. In Fig. 3 an example is shown in which the value of Vcc decreases from 5.5 volts (Vcc(U)) to 4.5 volts (Vcc(L)) during the standby period. The above-mentioned fluctuation occurs, or the fluctuation of other devices connected to the power source occur, because the electrical structure of the constant voltage power supply is simplified in order to reduce the production cost. During the standby period the voltage of the clock $\phi_0$ is low, the voltage of the clock $\overline{\phi_0}$ is high and the voltage Vcc is 5.5 volts causing both the nodes N2 and N3 to be charged up to the voltage of (5.5 volts–Vth). However, if the voltage Vcc decreases to 4.5 volts during the standby period, the voltages of the nodes N2 and N3 (5.5 volts–Vth) do not change, because there is no discharge path. The reason there is no discharge path is that the transistor Q4 holds off, and the transistor Q3 goes to the off state because the gate voltage of Q3 changes to 4.5 volts from 5.5 volts due to the power supply fluctuation. When the voltage of the nodes N2 and N3 is held, the rising of the clock $\phi_1$ is delayed. In order to raise the clock $\phi_1$, it is necessary that the transistors Q10 and Q12 are turned off. However, it takes time for the voltage of the node N2 to fall to the low level at which the transistors Q10 and Q12 are turned off, because the voltage of the node N2 is 1 volt higher than the voltage of (4.5 volts–Vth) in Fig. 2. During the delay time when the voltage is falling at the node N2, a delay in the rising of the clock $\phi_1$ occurs. In Fig. 3, waveforms indicated by lines N2', N3', N5' and $\phi_1$', show the variation with time of the voltages at the nodes N2, N3 and N5 and the voltage of the clock $\phi_1$

without a power supply fluctuation, as compared with broken lines N2, N3 N5 and $\phi_1$, which show the variation of the corresponding voltages when a fluctuation occurs in the power supply.

An object of the present invention is to provide a semiconductor buffer circuit in which the delay in the output clock caused by fluctuation of the voltage of the power supply is decreased, thereby providing a shorter access time.

According to one aspect of the present invention, there is provided a semiconductor buffer circuit to be energised by a power source voltage to generate an output clock signal in response to an input clock signal and an inverted input clock signal, the circuit comprising an input stage delay circuit for receiving the input clock signal and the inverted input clock signal and for generating an output signal at a node in response thereto, which node is charged up and maintained at a high level during a standby period; a bootstrap circuit for generating a boosted signal in response to the output signal of the input stage delay circuit, the bootstrap circuit including a first field effect transistor having a gate connected to the node to receive the output signal of the input stage delay circuit, and an output circuit for generating the output clock signal, the output circuit including a second field effect transistor having a gate operatively connected to the bootstrap circuit for receiving the boosted signal; characterised by a current leak circuit connected to the node of the input stage delay circuit for maintaining, during the standby period, the voltage of the node at a value related to the power source voltage by leaking excess charges from the node to lower the voltage level of the node.

According to a further aspect of the present invention, there is provided a semiconductor buffer circuit to be energised by a power source voltage to generate an output clock signal in response to an input clock signal and an inverted input clock signal, the circuit comprising an input stage delay circuit for receiving the input clock signal and the inverted input clock signal and for generating an output signal at a first node in response thereto, which first node is charged up and maintained at a high level during a standby period; a bootstrap circuit for generating a boosted signal in response to the output signal of the input stage delay circuit, the bootstrap circuit including a second node for receiving the output of the input stage delay circuit, the bootstrap circuit being operative to raise the voltage of the second node by the bootstrap operation; the bootstrap circuit further including a first stage transistor interconnecting the first node and the second node; and an output circuit for receiving the boosted signal and for generating the output clock signal; characterised by a current leak circuit connected to the second node for maintaining, during the standby period, the voltage of the first node at a value related to the power source voltage by leaking excess charges at the first node to lower the voltage level of that node.

According to another aspect of the present invention, there is provided a semiconductor buffer circuit to be energised by a power source voltage for generating an output clock signal in response to an input clock signal and an inverted clock signal, the circuit comprising an input stage delay circuit for receiving the input clock signal and the inverted input clock signal and for generating an output signal at a first node in response thereto, the first node being charged up and maintained at a high level during a standby period; a bootstrap circuit for generating a boosted signal in response to the output signal of the input stage delay circuit, the bootstrap circuit including a second node between a first transistor and a second transistor in the first stage and a first transistor in the second stage of the bootstrap circuit for receiving the output of the input stage delay circuit, the bootstrap circuit being operative to raise the voltage of the second node by the bootstrap operation; and the second transistor the bootstrap circuit being effective to isolate the first and second nodes from each other during the standby period; and an output circuit for receiving the boosted signal and for generating the output clock signal; characterised by two current leak circuits, one of which connects the second node to one pole of the power source, and the other of which connects the first node to one pole of the power source, for maintaining, during the standby period, the voltages of the nodes which are charged during a standby period at a value responsive to the power source voltage by leaking excess charges at the nodes to lower the voltage levels of the nodes.

Embodiments of the invention will now be described, by way of example, with reference to the accompanying drawings, in which:

Figs. 1, 2, and 3 are a circuit diagram and waveform diagrams, respectively, of an example of a conventional clock amplifier circuit as described above,

Fig. 4 is a circuit diagram of a semiconductor buffer circuit according to a first embodiment of the present invention,

Fig. 5 is a waveform diagram of the circuit of Fig. 4,

Fig. 6 is a circuit diagram of a semiconductor buffer circuit according to a second embodiment of the present invention,

Fig. 7 is a waveform diagram of the circuit of Fig. 6,

Fig. 8 is a circuit diagram of another example of a conventional clock amplifier circuit,

Fig. 9 is a circuit diagram of a semiconductor buffer circuit according to a third embodiment of the present invention,

Figs. 10a, b and c are circuit diagrams showing various modified current leak circuits used for embodiments of the present invention.

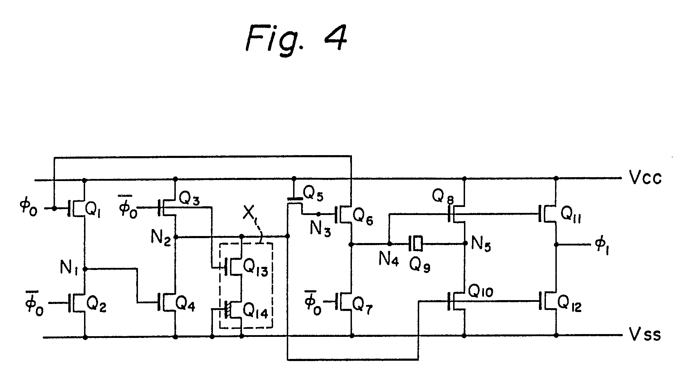

Referring to Fig. 4, a semiconductor buffer circuit according to a first embodiment of the present invention has a power source fluctuation compensating circuit (current leak circuit) X enclosed by a broken line. Such circuit is not provided in the conventional circuit of Fig. 1. The circuit X comprises a series connection of an enhancement-Type MOS transistor Q13 for a leaking current turned on during a standby period and a depletion-type MOS transistor Q14 for limiting the current. The circuit X is connected between the node N2 and the low voltage side Vss of the power supply. The node N2 is the connecting node between the transistor Q3, which turns on during the standby period and is used for charging, and the transistor Q4, which turns on during an active period and is used for discharging. In this example the "on" and "off" states of the transistor Q13 are controlled by the clock $\overline{\phi_0}$, but alternatively another signal which corresponds to the clock $\overline{\phi_0}$ in the IC can be used instead of the clock $\overline{\phi_0}$ for this purpose.

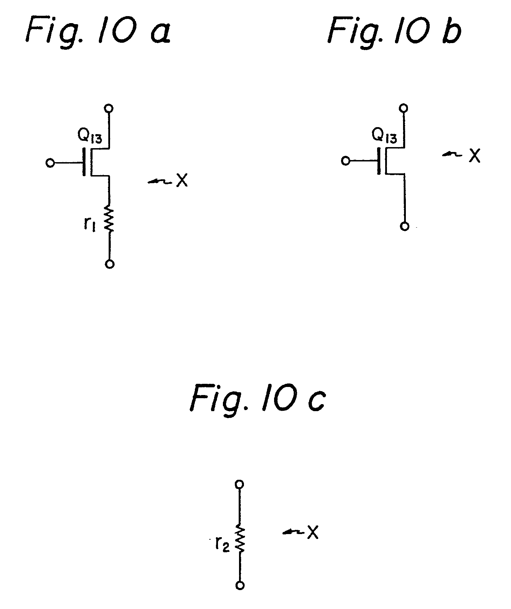

Furthermore, alternative current control elements can be substituted in place of the transistor Q14, such as a resistor r1 (Fig. 10a). Furthermore, the transistor Q14 can be omitted, if the resistance of the transistor Q13 can be made high by adjusting the width/length of the channel thereof (Fig. 10b). Also, instead of the transistors Q13 and Q14, a resistor r2 can be used (Fig. 10c). Thus, the function required of the circuit X is to allow a small amount of current to leak during the standby period to cause the voltage of the nodes N2 and N3 to fall to the voltage (Vcc–Vth) at that time.

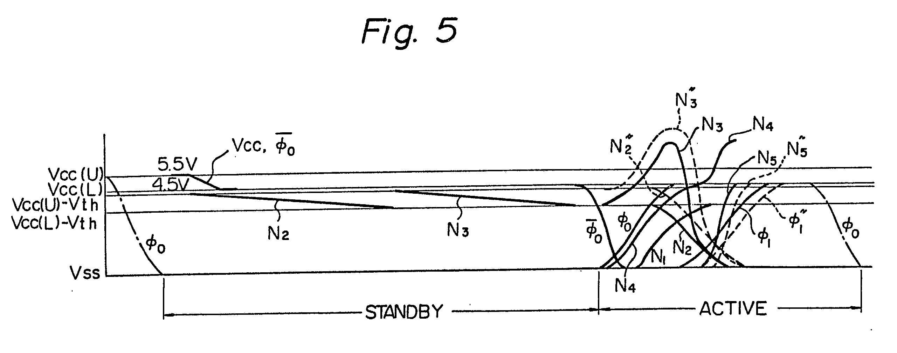

When the above-mentioned power source fluctuation compensating circuit X is connected, the nodes N2 and N3 are charged at the beginning of the standby period to a voltage of (5.5 volts–Vth) by the voltage Vcc which is equal to 5.5 volts; then, when the voltage Vcc falls to 4.5 volts, the charge on the node N2 is discharged through the circuit X until the voltage of the node N2 falls to (4.5 volts–Vth), as shown in Fig. 5. In the above description the voltage of the node N2 falls, more specifically, to a voltage of (4.5 volts–Vth–ΔV), where the voltage drop ΔV is caused by the resistance of the transistor Q3 when the transistor turns on. However, the voltage drop ΔV is negligible. When the voltage of the node N2 falls to (4.5 volts–Vth–ΔV), the transistor Q5 turns on, the charge on the node N3 flows to the node N2, and the voltage of the node N3 changes to be equal to the voltage of (4.5 volts–Vth–ΔV), which is equal to the voltage of the node N2. Therefore, the effect of the decrease in Vcc from 5.5 volts to 4.5 volts, namely the delay in the rising of the clock $\phi_1$, does not appear during the active period, if the voltage of Vcc changes from 5.5 volts to 4.5 volts during the standby period. Since the current which flows through the circuit X is very small, the charging of the node N2 takes place unhindered.

In a circuit in which the clock $\overline{\phi_0}$ synchronizes with the clock $\phi_0$ and the falling of the clock $\overline{\phi_0}$ and the rising of the clock $\phi_1$ occur simultaneously, the transistor 13 is not necessary. Since the nodes N2 and N3 are charged through the transistor Q3, if the circuit X consists of only a leakage resistance the voltages of the nodes N2 and N3 can be held to the voltage of (Vcc–Vth) at that time.

However, usually the clock $\overline{\phi_0}$ does not synchronise with the clock $\phi_0$; in some cases the clock $\overline{\phi_0}$ falls after a while the clock $\phi_0$ rises. In this case, if the circuit X consists of only a leakage resistance, the voltages of the nodes N2 and N3 would fall excessively between the falling time of the clock $\overline{\phi_0}$ and the rising time of the clock $\phi_0$, and, accordingly, the transistor Q13 is necessary. In order to compare this with the case in which no current leak circuit X is provided, the waveforms for the latter case are shown in broken lines in Fig. 5.

In the above-mentioned embodiment, it is assumed that the voltage Vth of the transistor Q3 is equal to the voltage Vth of the transistor Q5. If the voltage Vth of the transistor Q5 is higher than that of the transistor Q3 because of nonuniformity of the transistor characteristics due to the manufacturing process, the transistor Q5 remains off, but nevertheless the voltage of the node N2 falls to the voltage (Vcc–Vth–ΔV). Then, although the voltage of the node N2 falls as described above, the voltage of the node N3 cannot fall. If the voltage of the node N3 is high, as mentioned above, the voltage of the node N3 rises higher during the active period, and then the rising of the output clock $\phi_1$ is delayed.

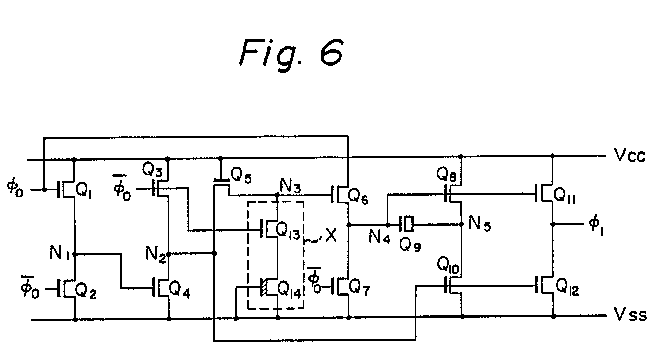

In Fig. 6, a semiconductor buffer circuit according to a second embodiment of the present invention is shown. In order to solve the above-mentioned problems, in the circuit in Fig. 6 the power supply fluctuation compensating circuit (current leak circuit) is connected to the node N3. By using the power source fluctuation compensating circuit the voltage of the node N3 can be the voltage (Vcc–Vth).

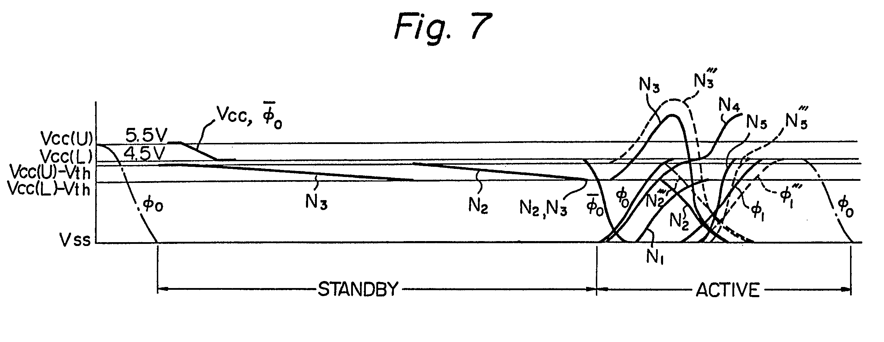

In Fig. 7, the waveforms occurring in the operation of the circuit in Fig. 6 are shown. The voltage of the node N2 discharges through the transistor Q5 and the circuit X and falls to the voltage (Vcc–Vth), the value of which is similar to the node N3. The waveforms in the circuit of Fig. 6, produced without the circuit X, are shown by broken lines in Fig. 7, which can be compared with the solid lines which indicate the waveforms of the circuit of Fig. 6 produced with the circuit X. If the circuit X is connected at the node N3, according to the second embodiment, the electrostatic capacity of the node N3 increases and the bootstrap effect is interrupted at the rising time of the clock $\phi_0$ and then the increase in the voltages of the nodes N3 and N4 is interrupted.

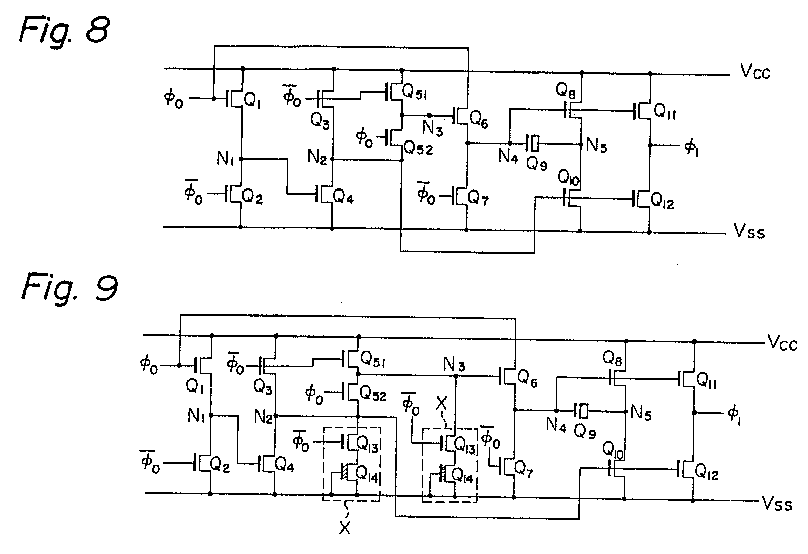

In Fig. 8, another example of a conventional clock amplifier circuit uses two transistors Q51 and Q52, instead of the transistor Q5 of Fig. 1. In this circuit, during the standby period, since the clock $\overline{\phi_0}$ is at a high level, the transistor Q3 turns on; the voltage of the node N2 is (Vcc–Vth); the transistor Q51 turns on; and the voltage of the node N3 is (Vcc–Vth). Then, since the voltage of the clock $\phi_0$ is at a low level, the transistor Q52 turns off and the node N2 is separated from the node N3. During the active period, since the voltage of the clock $\phi_0$ is at a high level, the transistor Q52 turns on and the circuit in Fig. 8 operates similarly to the circuit of Fig. 1. Also, in the case in which the voltage Vcc changes before the active period, the voltages of the nodes N2 and N3 remain at an excessively high level. In this circuitry, if a power source fluctuation compensating circuit is connected to either the node N2 or the node N3, since the transistor Q52 is off during the standby period, when the voltage of the power supply changes, the voltage of the node to which the power supply fluctuation compensating circuit is not connected remains at a high voltage.

In order to solve this problem, a semiconductor buffer circuit is proposed, according to a third embodiment of the present invention, as shown in Fig. 9. In this circuit, two power source fluctuation compensating circuits X and X' are connected between the node N2 and Vss and between the node N3 and Vss, respectively.

Below, the cases are explained in which the voltage of the power supply is fixed at 5.5 volts, and in which the voltage of the power supply rises up from 4.5 volts to 5.5 volts, respectively.

In the case in which the voltage of the power supply is 5.5 volts, generally at the high voltage of the power supply the mutual conductance gm increases, then the operating speed increases and there is no bad influence. An explanation is given referring to Fig. 1. When the voltage of the power supply Vcc is high, the voltages of the nodes N2 and N3 are high and the high level of the clock $\phi_0$ rises further. Then the voltage of the node N1 rises further and the gm of the transistor Q4 is higher than the gm of the transistor Q4 at the low value of Vcc. Since the gm of the transitor Q4 is high, the discharging speed at the nodes N2 and N3 is high.

Now the case will be described in which the voltage of the power supply rises from 4.5 volts to 5.5 volts. When Vcc rises from 4.5 volts to 5.5 volts, the voltage of the clock $\overline{\phi_0}$ rises from 4.5 volts to 5.5 volts, for the following reasons. The clock $\overline{\phi_0}$ is generated by a similar circuit to that shown in Fig. 1, and when the voltage of Vcc is 4.5 volts and the voltage of the clock $\phi_1$ is at a high level (4.5 volts), the voltage of the node N4 is greater than (Vcc+Vth) i.e. (4.5 volts+Vth). Also, the voltage of the node N5 is the voltage Vcc. Hence, when the voltage Vcc rises from 4.5 volts to 5.5 volts, the voltage of the node N5 rises from 4.5 volts to 5.5, volts through the transistor Q8. Since the voltage of the node N5 increases the voltage of the node N4 through the transistor Q9, although the voltage of Vcc rises to 5.5 volts, the voltage of the node N4 rises to the voltage of (Vcc+Vth), i.e. (5.5 volts+Vth), and the voltage of the clock $\phi_1$ rises to 5.5 volts.

After the voltage Vcc has risen from 4.5 volts to 5.5 volts, the voltage of the nodes N2 and N3 is equal to the voltage of the nodes when the voltage Vcc is fixed at 5.5 volts. Hence, there is no delay in the operating time.

## Claims

1. A semiconductor buffer circuit to be energised by a power source voltage (Vcc, Vss) to generate an output clock signal ($\phi_1$) in response to an input clock signal ($\phi_1$) and an inverted input clock signal ($\overline{\phi_0}$), the circuit comprising an input stage delay circuit ($Q_1$—$Q_4$) for receiving the input clock signal and the inverted input clock signal and for generating an output signal at a node (N2) in response thereto, which node is charged up and maintained at a high level during a standby period; a bootstrap circuit ($Q_5$, $Q_6$, $Q_7$, $Q_8$, $Q_{10}$) for generating a boosted signal in response to the output signal of the input stage delay circuit, the bootstrap circuit including a first field effect transistor ($Q_{10}$) having a gate connected to the node to receive the output signal of the input stage delay circuit; and an output circuit ($Q_{11}$, $Q_{12}$) for generating the output clock signal, the output circuit including a second field effect transistor ($Q_{11}$) having a gate operatively connected to the bootstrap circuit for receiving the boosted signal; characterised by a current leak circuit (X) connected to the node (N2) of the input stage delay circuit for maintaining, during the standby period, the voltage of the node at a value related to the power source voltage by leaking excess charges from the node to lower the voltage level of the node.

2. A semiconductor buffer circuit to be energised by a power source voltage (Vcc, Vss) to generate an output clock signal ($\phi_1$) in response to an input clock signal ($\phi_0$) and an inverted input clock signal ($\overline{\phi_0}$), the circuit comprising an input stage delay circuit ($Q_1$—$Q_4$) for receiving the input clock signal and the inverted input clock signal and for generating an output signal at a first node (N2) in response thereto, which first node (N2) is charged up and maintained at a high level during a standby period; a bootstrap circuit ($Q_5$, $Q_6$, $Q_7$, $Q_8$, $Q_{10}$) for generating a boosted signal in response to the output signal of the input stage delay circuit, the bootstrap circuit including a second node (N3) for receiving the output of the input stage delay circuit, the bootstrap circuit being operative to raise the voltage of the second node by the bootstrap operation; the bootstrap circuit further including a first stage transistor (Q5) interconnecting the first node and the second node; and an output circuit ($Q_{11}$, $Q_{12}$) for receiving the boosted signal and for generating the output clock signal characterised by a current leak circuit (X) connected to the second node (N3) for maintaining, during the standby period, the voltage of the first node at a value related to the power source voltage by leaking excess charges at the first node to lower the voltage level of that node.

3. A semiconductor buffer circuit to be energised by a power source voltage (Vcc, Vss) for generating an output clock signal ($\phi_1$) in response to an input clock signal ($\phi_0$) and an inverted clock signal ($\overline{\phi_0}$), the circuit comprising an input stage delay circuit ($Q_1$—$Q_4$) for receiving the input clock signal and the inverted input clock signal and for generating an output signal at a first node (N2) in response thereto, the first node being charged up and maintained at a high level during a standby period; a bootstrap circuit ($Q_{51}$, $Q_{52}$, $Q_6$, $Q_7$, $Q_8$, $Q_{10}$) for generating a boosted signal in response to the output signal of the input stage delay circuit, the bootstrap circuit including a second node (N3) between a first transistor ($Q_{51}$) and a second transitor ($Q_{52}$) in the first stage and a first transistor ($Q_6$) in the second stage of the bootstrap circuit for receiving the output of the input stage delay circuit, the bootstrap circuit being operative to raise the voltage of the second node by the bootstrap operation and a part ($Q_{52}$) of the bootstrap circuit being effective to isolate the first and second nodes from each other during the standby period; and an output circuit ($Q_{11}$, $Q_{12}$) for receiving the boosted signal and for generating the output clock signal; characterised by two current leak circuits (X, X') one of which (X) connects the second node (N3) to one pole (Vss) of the power source, and the other of which (X') connects the first node (N2) to one pole (Vss) of the power source, for maintaining, during the standby period, the voltages of the nodes which are charged during a standby period at a value responsive to the power source voltage by leaking excess charges at the nodes to lower the voltage levels of tne nodes.

4. A semiconductor buffer circuit as claimed in any one of Claims 1, 2 or 3, characterised in that the current leak circuit (X, X') comprises field effect transistors ($Q_{13}$, $Q_{14}$) connected in series.

5. A semiconductor buffer circuit as claimed in any one of Claims 1, 2 or 3, characterised in that the current leak circuit (X, X') comprises a field effect transistor ($Q_{13}$) and a resistor ($r_1$) connected in series.

6. A semiconductor buffer circuit as claimed in any one of Claims 1, 2 or 3, characterised in that the current leak circuit (X, X') comprises a field effect transistor ($Q_{13}$).

7. A semiconductor buffer circuit as claimed in any one of Claims 1, 2 or 3, characterised in that the current leak circuit (X, X') comprises a resistor ($r_2$).

**Patentansprüche**

1. Halbleiterpufferschaltung, die von einer Energiequellenspannung (Vcc, Vss) mit Energie versogt wird, um ein Ausgangstaktsignal ($\phi_1$) in Abhängigkeit von einem Eingangstaktsignal ($\phi_0$) und einem invertierten Taktsignal ($\overline{\phi_0}$) zu erzeugen, mit einer Eingangsstufen-Verzögerungsschaltung ($Q_1$—$Q_4$) zum Empfang des Eingangstaktsignals un des invertierten Eingangstaktsignals und zur Erzeugung eines Ausgangssignals in Abhängigkeit von diesen an einem Knotenpunkt (N2), der während einer Bereitstellungsperiode aufgeladen und auf einem hohen Pegel gehalten wird; einer, zur Erzeugung eines verstärkten Signals in Abhängigkeit von dem Ausgangssignal der Eingangs-stufen-verzögerungsschaltung dienenden, Boot-

strap-Schaltung ($Q_5$, $Q_6$, $Q_7$, $Q_8$, $Q_{10}$), die einen ersten Feldeffekttransistor ($Q_{10}$) umfaßt, dessen Gateelektrode mit den Knotenpunkt verbunden ist, um das Ausgangssignal der Eingangsstufen-Verzögerungsschaltung zu emfangen; und einer Ausgangsschaltung ($Q_{11}$, $Q_{12}$), zur Erzeugung des Ausgangstaktsignals, welche einen zweiten Feldefektransistor ($Q_{11}$) umfaßt, dessen Gate wirkungsmäßig mit der Bootstrap-Schaltung verbunden ist, um das verstärkte Signal zu empfangen; gekennzeichnet, durch eine Stromableitungsschaltung (X), die mit dem Knotenpunkt (N2) der Eingangsstufen-Verzögerungsschaltung verbunden ist, um während der Bereitstellungsperiode durch Ableitung von Überschußladungen von dem Knotenpunkt, um den Spannungspegel des Knotenpunktes zu erniedrigen, die Spannung des Knotenpunktes bei einem Wert in Relation zu der Energiequellenspannung zu halten.

2. Halbleiterpufferschaltung, die von einer Energiequellenspannung (Vcc, Vss) mit Energie versoft wird, um ein Ausgangstaktsignal ($\phi_1$) in Abhängigkeit von einem Eingangstaktsignal ($\phi_1$) und einem invertierten Eingangstaktsignal ($\phi_0$) zu erzeugen, mit einer Eingangs-stufen-Verzögerungsschaltung ($Q_1$—$Q_4$) zum Empfang des Eingangstaktsignals und des invertierten Eingangstaktsignals und zur Erzeugung eines Ausgangssignals in Abhängigkeit von diesen an einem ersten Knotenpunkt (N2), der währenf einer Bereitstellungsperiode aufgeladen und auf einem hohen Pegel gehalten wird; einer, zur Erzeugung eines verstärken Signals in Abhängigkeit von dem Ausgangssignal der Eingangsstufen-Verzögerungsschaltung dien-enden, Bootstrap-Schaltung ($Q_5$, $Q_6$, $Q_7$, $Q_8$, $Q_{10}$), die einen zweiten Knotenpunkt (N3) zum Empfang des Ausgangs der Eingangsstufen-Verzögerungsschaltung umfaßt und im Betrieb die Spannung des zweiten Knotenpunktes durch die Bootstrap-Operation erhöht; wobei die Bootstrap-Schaltung ferner einen ersten Stufen-transistor ($Q_5$) unfaßt, welcher den ersten Knotenpunkt und den zweiten Knotenpunkt miteinander verbindet; und eine Ausgangsschaltung ($Q_{11}$, $Q_{12}$) zum Empfang des verstärken Signals und zur Erzeugung des Ausgangstaktsignals; ge-kennzeichnet durch eine Stromableitungs-schaltung (X), de mit dem zweiten Knotenpunkt (N3) verbunden ist, um, währen der Bereitstellungsperiode, durch Ableitung überschüssiger Ladungen bei dem ersten Knotenpunkt, um den Spannungswert dieses Knotenpunktes zu erniedrigen, die Spannung des ersten Knotenpunktes auf einem Wert in Relation zu der Energiequellenspannung zu halten.

3. Halbleiterpufferschaltung, die von einer Energiequellenspannung (Vcc, Vss) mit Energie versorgt wird, um ein Ausgangstaktsignal ($\phi_1$) in Anhängigkeit von einem Eingangstaktsignal ($\phi_0$) und einem invertierten Taktsignal ($\overline{\phi_0}$) erzeugen, welche umfaßt: eine Eingangs-stufen-Verzögerungsschaltung ($Q_1$—$Q_4$) zum Empfang des Eingangstaktsignals und des invertierten Eingangstaktsignals und zur Erzeugung eines Ausgangssignals in Abhängigkeit von diesen, an einem ersten Knotenpunkt, der währen einer Bereitstellungsperiode aufgeladen und auf einem hohen Pegel gehalten wird; einer Bootstrap-Schaltung ($Q_{51}$, $Q_{52}$, $Q_6$, $Q_7$, $Q_8$, $Q_{10}$) zur Erzeugung eines verstärken Signals in Abhängigkeit von dem Ausgangssignal der Eingangsstufen-Verzögerungsschaltung, wobei die Bootstrap-Schaltung einen zweiten Knotenpunkt ($N3$) zwischen einem ersten Transistor ($Q_{51}$) und einem zweiten Transistor ($Q_{52}$) in der ersten Stufe und einen ersten Transistor ($Q_6$) in der zweiten Stufe der Bootstrap-Schaltung zum Empfang des Ausgangs der Eingangsstufen-Verzögerungsschaltung umfaßt, wobei die Bootstrap-Schaltung im Betrieb die Spannung des zweiten Knotenpunktes durch die Bootstrap-Operation erhöht; und einen Teil ($Q_{52}$) der Bootstrap-Schaltung, der bewirkt, daß der erste und zweite Knotenpunkt während der Bereitstellungsperiode voneinander isoliert werden; und ein Ausgangsschaltung ($Q_{11}$, $Q_{12}$) zum Empfang des verstärken Signals und zur Erzeugung des Ausgangstaktsignals; gekennzeichnet durch zwei Stromableitungsschaltungen ($X$, $X'$), von denen eine ($X$) den zweiten Knotenpunkt ($N3$) mit einem Pol ($Vss$) der Energiequelle und die andere ($X'$) den ersten Knotenpunkt ($N2$) mit einem Pol ($Vss$) der Energiequelle verbindet, um während der Bereitstellungsperiode, durch Ableitung überschüssiger Ladung bei den Knotenpunkten, um den Spannungspegel der Knotenpunkte zu erniedrigen, die Spannungen der Knotenpunkte aufrechtzuerhalten, welche während der Bereitstellungsperiode auf einen Wert aufgeladen werden, der von der Energiequellenspannung abhängt.

4. Halbleiterpufferschaltung nach einem der Ansprüche 1, 2 oder 3, dadurch gekennzeichnet, daß die Stromableitungsschatung ($X$, $X'$) in Reihe geschaltete Feldeffekttransistoren ($Q_{13}$, $Q_{14}$) umfaßt.

5. Halbleiterpufferschaltung nach einem der Ansprüche 1, 2 oder 3, dadurch gekennzeichnet, daß die Stromableitungsschaltung ($X$, $X'$) einen Feldeffekttransistor ($Q_{13}$) und einen Widerstand ($r_1$) umfaßt, die in Reihe geschaltet sind.

6. Halbleiterpufferschaltung nach einem der Ansprüche 1, 2 oder 3, dadurch gekennzeichnet, daß die Stromableitungsschaltung ($X$, $X'$) einen Feldeffekttransistor ($Q_{13}$) umfaßt.

7. Halbleiterpufferschaltung nach einem der Ansprüche 1, 2 oder 3, dadurch gekennzeichnet, daß die Stromableitungsschaltung ($X$, $X'$) einen Widerstand ($r_2$) umfaßt.

**Revendications**

1. Circuit tampon semiconducteur devant être excité par la tension d'une source d'alimentation ($Vcc$, $Vss$) afin de produire un signal d'horloge de sortie ($\phi_1$) en réponse à un signal d'horloge d'entrée ($\phi_0$) et un signal d'horloge d'entrée inversé ($\overline{\phi_0}$), le circuit comprenant un circuit retardateur d'étage d'entrée ($Q_1$ à $Q_4$) servant à recevoir le signal d'horloge d'entrée et le signal d'horloge d'entrée inversé et à produire un signal de sortie en un noeud ($N_2$) en réponse à ceux-ci, lequel noeud se charge et est maintenu à niveau haut pendant une période d'attente; un circuit de bootstrap ($Q_5$, $Q_6$, $Q_7$, $Q_8$, $Q_{10}$) servant à produire un signal renforcé en réponse au signal de sortie du circuit retardateur d'étage d'entrée, le circuit de bootstrap comportant un premier transistor à effet de champ ($Q_{10}$) dont la grille est connectée au noeud afin de recevoir le signal de sortie du circuit ratardateur d'étage d'entrée; et un circuit de sortie ($Q_{11}$, $Q_{12}$) servant à produire le signal d'horloge de sortie, le circuit de sortie comportant un deuxième transistor à effet de champ ($Q_{11}$) dont la grille est fonctionnellement connectée au circuit de bootstrap afin de recevoir le signal renforcé; caractérisé par un circuit de fuite de courant ($X$) raccordé au noeud ($N_2$) du circuit retardateur d'étage d'entrée afin de maintenir, pendant la période d'attente, la tension de noeud sur une valeur associée à la tension de la source d'alimentation électrique par le fait que les charges en excès fuient du noeud pour abaisser le niveau de tension du noeud.

2. Circuit tampon semiconducteur devant être excité par la tension d'une source d'alimentation électrique ($Vcc$, $Vss$) afin de produire un signal d'horloge de sortie ($\phi_1$) en réponse à un signal d'horloge d'entrée ($\phi_0$) et un signal d'horloge d'entrée inversé ($\overline{\phi_0}$), le circuit comprenant un circuit retardateur d'étage d'entrée ($Q_1$ à $Q_4$) servant à recevoir le signal d'horloge d'entrée et le signal d'horloge d'entrée inversé et à produire un signal de sortie sur un premier noeud ($N_2$) en réponse à ceux-ci, lequel premier noeud ($N_2$) se charge em est maintenu à un niveau haut pendant une période d'attente; un circuit de bootstrap ($Q_5$, $Q_6$, $Q_7$, $Q_8$, $Q_{10}$) servant à produire un signal renforcé en réponse au signal de sortie du circuit retardateur d'étage d'entrée, le circuit de bootstrap comportant un deuxième noeud ($N_3$) servant à recevoir le signal de sortie du circuit retardateur d'étage d'entrée, le circuit de bootstrap ayant pour fonction d'élever la tension du deuxième noeud par un effet de bootstrap; le circuit de bootstrap comportant en outre un transistor de premier étage ($Q_5$) interconnectant le premier noeud et le deuxième noeud; et un circuit de sortie ($Q_{11}$, $Q_{12}$) servant à recevoir le signal renforcé et à produire le signal d'horloge de sortie; caractérisé par un circuit de fruite de courant ($X$) raccordé au deuxième noeud ($N_3$) afin de maintenir, pendant la période d'attente, la tension du premier noeud sur une valeur associée à la tension de la source d'alimentation électrique en laissant fuir les charges en excès sur le premier noeud pour abaisser le niveau de tension de ce noeud.

3. Circuit tampon semiconducteur devant être excité par la tension d'une source d'alimentation électrique ($Vcc$, $Vss$) afin de produire un signal d'horloge de sortie ($\phi_1$) en réponse à un signal d'horloge d'entrée ($\phi_0$) et un signal d'horloge

inversé ($\overline{\phi_0}$), le circuit comprenant un circuit retardateur d'étage d'entrée ($Q_1$, à $Q_4$) servant à recevoir le signal d'horloge d'entrée et le signal d'horloge d'entrée inversé et à produire un signal de sortie sur un premier noeud ($N_2$) en réponse à ceux-ci, le premier noeud se chargeant et étant maintenu à un niveau haut pendant une période d'attente; une circuit de bootstrap ($Q_{51}$, $Q_{52}$, $Q_6$, $Q_7$, $Q_8$, $Q_{10}$) servant à produire un signal renforcé en réponse au signal de sortie du circuit retardateur d'étage d'entrée, le circuit de bootstrap comportant un deuxième noeud ($N_3$) entre un premier transistor ($Q_{51}$) et un deuxième transistor ($Q_{52}$) du premier étage et un premier transistor ($Q_6$) du deuxième étage du circuit de bootstrap afin de recevoir le signal de sortie du circuit retardateur d'étage d'entrée, le circuit de bootstrap ayant pour fonction d'élever la tension du deuxième noeud par un effet de bootstrap; et une partie ($Q_{52}$) du circuit de bootstrap ayant pour effet d'isoler les premier et deuxième noeuds l'une de l'autre pendant la période d'attente; et un circuit de sortie ($Q_{11}$, $Q_{12}$ servant à recevoir le signal renforcé et à produire le signal d'horloge de sortie; caractérisé par deux circuits de fuite de courant (X, X') dont l'un (X) raccorde le deuxième noeud ($N_3$) à un premier pôle (Vss) de la source d'alimentation électrique, et dont l'autre (X') raccorde le premier noeud ($N_2$) à un premier pôle (Vss) de la source d'alimentation électrique, servant à maintenir, pendant la période la période d'attente, les tensions des noeuds qui se sont chargés pendant une période d'attente sur une valeur répondant à la tension de la source d'alimentation électrique en laissant fuir les charges en excès sur les noeuds afin d'abaisser les niveaux de tension des noeuds.

4. Circuit tampon semiconducteur selon l'une quelconque des revendications 1, 2 ou 3, caractérisé en ce que le circuit de fuite de courant (X, X') comprend des transistors à effet de champ ($Q_{13}$, $Q_{14}$) connectés en série.

5. Circuit tampon semiconducteur selon l'une quelconque des revendications 1, 2 ou 3, caractérisé en ce que le circuit de fuite de courant (X, X') comprend un transistor à effet de champ ($Q_{13}$) et une résistance ($r_1$) connectés en séries.

6. Circuit tampon semiconducteur selon l'une quelconque des revendications 1 , 2 ou 3, caractérisé en ce que le circuit de courant de fuite (X, X') comprend un transistor à effet de champ ($Q_{13}$).

7. Circuit tampon semiconducteur selon l'une quelconque des revendications 1, 2 ou 3, caractérisé en ce que le circuit de fuite de courant (X, X') comprend une résistance ($r_2$).

# Fig. 1

Fig. 2

Fig. 3

# Fig. 4

Fig. 5

*Fig. 6*

Fig. 7

0 052 504

*Fig. 8*

*Fig. 9*

# Fig. 10 a

# Fig. 10 b

# Fig. 10 c